# EUROPEAN PATENT APPLICATION

(11) **EP 4 823 304 A1**
(43) Date of publication of application: **14.10.2026**
(21) Application number: 26167012.9
(22) Date of filing: 24.03.2026
(51) Int. Cl.: H10N 30/076, H10N 30/853

(54) **PIEZOELECTRIC STACK AND PIEZOELECTRIC STACK MANUFACTURING METHOD**

(30) Priority: 28.03.2025 JP 2025057240
(71) Applicant: SUMITOMO CHEMICAL COMPANY, LIMITED, Tokyo 103-6020 (JP)
(72) Inventor: TANAKA, Yasunori, Hitachi-shi, Ibaraki, 3191418 (JP); SHIBATA, Kenji, Hitachi-shi, Ibaraki, 3191418 (JP); WATANABE, Kazutoshi, Hitachi-shi, Ibaraki, 3191418 (JP); KURODA, Toshiaki, Hitachi-shi, Ibaraki, 3191418 (JP)
(74) Representative: Vossius & Partner Patentanwälte Rechtsanwälte mbB

(57) **Abstract**

There is provided a piezoelectric stack including: a substrate; a bottom electrode film on the substrate; and a piezoelectric film on the bottom electrode film, which is composed of a perovskite oxide represented by a general formula ABO₃, in which A site contains K and Na and B site contains Nb, wherein measurement of a crystal orientation on an upper surface of the piezoelectric film by electron backscatter diffraction and calculation of an area rate of (001), (110), and (111) show that a percentage of a total area rate of the (110) and the (111) relative to a total area rate of the (001), the (110), and the (111) is more than 10% and 70% or less, an arithmetic mean roughness on the upper surface is 8 nm or less, and a root mean square roughness on the upper surface is 12 nm or less.

## Description

### BACKGROUND

### Technical Field

The present disclosure relates to a piezoelectric stack and a piezoelectric stack manufacturing method.

### Description of Related Art

A piezoelectric material is widely used in a functional electronic component (device) such as an actuator. One of the piezoelectric materials used is a ferroelectric material (i.e., a KNN-based ferroelectric material) that is composed of a perovskite oxide represented by a general formula ABO₃, in which A site contains K and Na and B site contains Nb. Then, there has been proposed a stack including a piezoelectric film (KNN film) deposited using the KNN-based ferroelectric material (see, for example, Patent literature 1).

### Citation List

### Patent Literature

[Patent literature 1] JP 2024-75901 A

### Summary of the Invention

### Technical Problem

An object of the present disclosure is to provide a piezoelectric stack having a piezoelectric film with good dielectric strength.

### Solution to Problem

According to one aspect of the present disclosure, there is provided a piezoelectric stack including:
a substrate;
a bottom electrode film on the substrate; and
a piezoelectric film on the bottom electrode film, which is composed of a perovskite oxide represented by a general formula ABO₃, in which A site contains K and Na and B site contains Nb,
wherein measurement of a crystal orientation on an upper surface of the piezoelectric film by electron backscatter diffraction and calculation of an area rate of (001), (110), and (111) show that a percentage of a total area rate of the (110) and the (111) relative to a total area rate of the (001), the (110), and the (111) is more than 10% and 70% or less,
an arithmetic mean roughness on the upper surface is 8 nm or less, and
a root mean square roughness on the upper surface is 12 nm or less.

According to another aspect of the present disclosure, there is provided a piezoelectric stack manufacturing method including:
depositing a bottom electrode film on a substrate; and
depositing a piezoelectric film composed of a perovskite oxide represented by a general formula ABO₃, in which A site contains K and Na and B site contains Nb, on the bottom electrode film by a sputtering method,
wherein the depositing the piezoelectric film includes depositing the piezoelectric film while rotating the substrate on which the bottom electrode film has been deposited at a rotation speed of 300 rpm or more and 1000 rpm or less.

### Advantageous Effects of Invention

According to the present disclosure, there is provided a piezoelectric stack having a piezoelectric film with good dielectric strength.

### Brief Description of the Drawings

[Fig. 1] Fig. 1 is a view showing one example of a cross-sectional structure of a piezoelectric stack according to one aspect of the present disclosure.
[Fig. 2] Fig. 2 is a view showing one example of a setting manner of an observation visual field when observing an upper surface of a piezoelectric film using an atomic force microscope (AFM).
[Fig. 3] Fig. 3 is a view showing one example of a configuration of a simplified piezoelectric element according to one aspect of the present disclosure.
[Fig. 4] Fig. 4 is a view showing one example of a schematic configuration of a piezoelectric element according to one aspect of the present disclosure.
[Fig. 5] Fig. 5 is a view showing one example of a schematic configuration of a piezoelectric device module according to one aspect of the present disclosure.
[Fig. 6] Fig. 6 is a view showing one example of a cross-sectional structure of a piezoelectric stack according to a modified example of one aspect of the present disclosure.
[Fig. 7A] Fig. 7A is an AFM image showing an upper surface portion of a KNN film in Sample 2.
[Fig. 7B] Fig. 7B is an AFM image showing an upper surface portion of the KNN film in Sample 5.

### Detailed Description of the Invention

### <One aspect of the present disclosure>

Hereinafter, one aspect of the present disclosure will be described with reference to the drawings.

### (1) Configuration of the piezoelectric stack

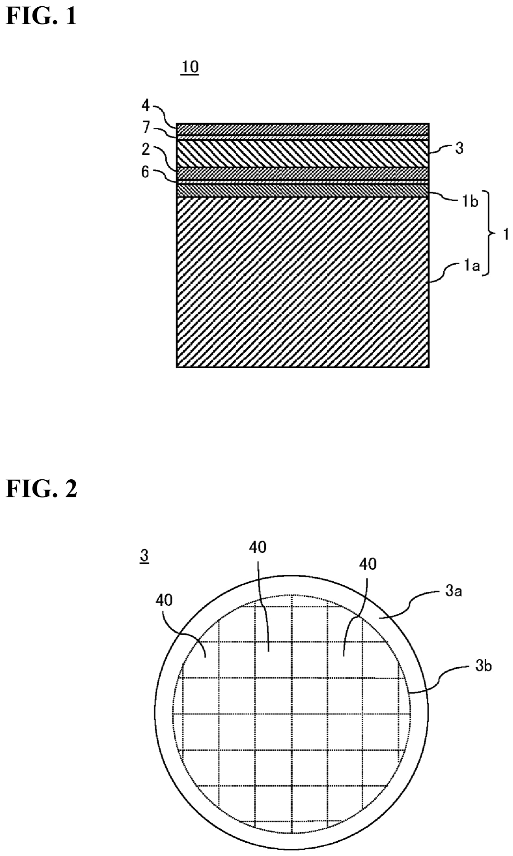

As shown in Fig. 1, a stack 10 having a piezoelectric film according to this embodiment (hereinafter also referred to as a piezoelectric stack 10) includes a substrate 1, a bottom electrode film 2, a piezoelectric film (piezoelectric thin film) 3, and a top electrode film 4.

As the substrate 1, a single crystal silicon (Si) substrate 1a on which a surface oxide film (SiO₂ film) 1b such as a thermal oxide film or a CVD (Chemical Vapor Deposition) oxide film is formed, i.e., a Si substrate having a surface oxide film, can be suitably used. Further, a Si substrate 1a having an insulating film composed of an insulating material other than SiO₂, instead of the surface oxide film 1b, can be used as the substrate 1. Alternatively, a Si substrate 1a having Si(100) or Si(111), etc., exposed on its surface, i.e., a Si substrate having no surface oxide film 1b or insulating film can be used as the substrate 1. In addition, an SOI (Silicon On Insulator) substrate or a quartz glass (SiO₂) substrate can also be used as the substrate 1. The thickness of the single crystal Si substrate 1a can be, for example, 300 µm or more and 1000 µm or less, and the thickness of the surface oxide film 1b can be, for example, 1 nm or more and 4000 nm or less.

The bottom electrode film 2 is deposited on the substrate 1. That is, the bottom electrode film 2 is provided between the substrate 1 and the piezoelectric film 3. The bottom electrode film 2 can be formed using, for example, platinum (Pt) and is a polycrystalline film. Hereinafter, the polycrystalline film deposited using Pt is also referred to as a Pt film. It is preferable that the (111) of the Pt film is parallel to the main surface of the substrate 1 (including a case where the (111) is inclined at an angle of ±5° or less with respect to the main surface of the substrate 1), i.e., the Pt film is oriented in a (111) direction. The Pt film being oriented in the (111) direction means that no peaks other than those due to the (111) are observed in the X-ray diffraction pattern obtained by X-ray diffraction (XRD) measured on the surface of the piezoelectric film 3. Thus, the main surface of the bottom electrode film 2 (the surface that serves as the base for the piezoelectric film 3) is preferably composed of the Pt(111). The bottom electrode film 2 can be deposited by a method such as a sputtering method or a vapor deposition method. As a material for the bottom electrode film 2, other than Pt, various metals such as gold (Au), ruthenium (Ru), or iridium (Ir), alloys containing these as main components, or metal oxides such as strontium ruthenium oxide (SrRuO₃, abbreviated as SRO) or lanthanum nickel oxide (LaNiO₃, abbreviated as LNO) can also be used. When the bottom electrode film 2 is deposited using the metal oxide, it is preferable that the crystals constituting the bottom electrode film 2 are preferentially oriented in the (001) direction with respect to the surface of the substrate 1. That is, it is preferable that the main surface of the bottom electrode film 2 is mainly composed of an SRO(001) or LNO(001). The crystals constituting the bottom electrode film 2 being oriented in the (001) direction means that the (001) of the crystals constituting the bottom electrode film 2 is parallel or approximately parallel to the main surface of the substrate 1. Further, the crystals constituting the bottom electrode film 2 being preferentially oriented in the (001) direction means that there are many crystals in which the (001) is parallel or approximately parallel to the main surface of the substrate 1. The bottom electrode film 2 can be a single layer film formed using any of the above metals, alloys containing any of the above metals as main components, or metal oxides. The bottom electrode film 2 may be a stack of the Pt film and a film mainly composed of SRO provided on the Pt film, or a stack of the Pt film and a film mainly composed of LNO provided on the Pt film. The thickness of the bottom electrode film 2 (when the bottom electrode film 2 is a stack, the total thickness of each layer) can be, for example, 100 nm or more and 400 nm or less.

A bottom adhesive layer 6 may be provided between the substrate 1 and the bottom electrode film 2 to improve adhesion therebetween. The bottom adhesive layer 6 may be, for example, a layer containing zinc (Zn) and oxygen (O) as main components (hereinafter also referred to as a "ZnO layer"). The ZnO layer can be formed using, for example, zinc oxide. The composition ratio of Zn and O constituting the ZnO layer preferably satisfies a relationship of Zn : O = 1 : 1, but is not limited thereto and some variation is acceptable. The ZnO layer is a polycrystalline layer. It is preferable that the (0001) of the ZnO layer is parallel to the main surface of the substrate 1 (including the case where the (0001) is inclined at an angle of ±5° or less with respect to the main surface of the substrate 1), i.e., the ZnO layer is oriented in the (0001) direction. The ZnO layer being oriented in the (0001) direction means that the intensity of a peak due to the (0002) is high in an X-ray diffraction pattern obtained by XRD measured on the surface of the piezoelectric film 3. Thus, the main surface of the ZnO layer (the surface that serves as the base for the bottom electrode film 2) is preferably composed of the ZnO (0001). The ZnO layer can be deposited by a method such as a sputtering method or a vapor deposition method. The thickness of the ZnO layer can be, for example, 1 nm or more and 200 nm or less, preferably 10 nm or more and 50 nm or less. The bottom adhesive layer 6 may be a layer whose main component is, for example, titanium (Ti), tantalum (Ta), titanium oxide (TiO₂), nickel (Ni), ruthenium oxide (RuO₂), iridium oxide (IrO₂), etc. Such a bottom adhesive layer 6 can also be deposited by a method such as a sputtering method or a vapor deposition method, and the thickness of the bottom adhesive layer 6 can be, for example, 1 nm or more and 200 nm or less, preferably 10 nm or more and 50 nm or less.

The piezoelectric film 3 is deposited on the bottom electrode film 2. The piezoelectric film 3 is composed of a perovskite oxide represented by a general formula ABO₃, in which A site contains potassium (K) and sodium (Na) and B site contains niobium (Nb). That is, the piezoelectric film 3 can be a film whose main component is alkali niobium oxide containing K, Na, Nb, and oxygen (O), and has a perovskite crystal structure. The piezoelectric film 3 can be formed using an alkali niobium oxide represented by a composition formula (K₁₋ₓNaₓ)NbO₃, that is, potassium sodium niobium oxide (KNN). The coefficient x [=Na/(K+Na)] in the above composition formula can be set within a range of 0 < x < 1, preferably 0.4 ≤ x ≤ 0.8. The piezoelectric film 3 is a KNN polycrystalline film (hereinafter also referred to as a KNN film 3). The KNN film 3 can be deposited by a sputtering method, a PLD (Pulsed Laser Deposition) method, etc. The thickness of the KNN film 3 can be, for example, 0.5 µm or more and 5 µm or less, preferably 1 µm or more and 3 µm or less.

The alkali niobium oxide constituting the KNN film 3 may further contain at least one element (dopant) selected from the group consisting of lithium (Li), magnesium (Mg), calcium (Ca), strontium (Sr), barium (Ba), bismuth (Bi), antimony (Sb), vanadium (V), indium (In), tantalum (Ta), molybdenum (Mo), tungsten (W), chromium (Cr), Ti, zirconium (Zr), hafnium (Hf), scandium (Sc), yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), lutetium (Lu), copper (Cu), zinc (Zn), silver (Ag), manganese (Mn), iron (Fe), cobalt (Co), Ni, aluminum (Al), Si, germanium (Ge), tin (Sn), and gallium (Ga). The concentration of these elements in the alkali niobium oxide can be, for example, 5 at.% or less (when a plurality of the above elements is contained, the total concentration is 5 at.% or less).

The majority of the crystals constituting the KNN film 3 are oriented in any one of the (001), (110), and (111) directions with respect to the main surface of the substrate 1 (Si substrate 1a when the substrate 1 is, for example, a Si substrate 1a having a surface oxide film 1b or an insulating film, etc.). In this specification, the crystals constituting the KNN film 3 being oriented in the (001) direction means that the (001) of the crystals constituting the KNN film 3 is parallel to the main surface of the substrate 1. Also, in this specification, KNN crystals oriented in the (001) direction (hereinafter also referred to as (001) KNN crystals) include crystals whose (001) is inclined at an angle of ±5° or less with respect to the main surface of the substrate 1. Also, KNN crystals oriented in the (110) direction (hereinafter also referred to as (110) KNN crystals) include crystals whose (110) is inclined at an angle of ±5° or less with respect to the main surface of the substrate 1. Also, KNN crystals oriented in the (111) direction (hereinafter also referred to as (111) KNN crystals) include crystals whose (111) is inclined at an angle of ±5° or less with respect to the main surface of the substrate 1. In this specification, the crystal system of KNN is considered to be a tetragonal system.

In the KNN film 3 in this aspect, the crystals constituting an outermost layer include at least one of (110) KNN crystals and (111) KNN crystals. Further, in the KNN film 3 in this aspect, the percentage of the area rate of the (110) and the (111) on the upper surface of the outermost layer is more than 10% and 70% or less.

Here, the "outermost layer of the KNN film 3" refers to a region ranging from an upper surface of the KNN film 3 to a predetermined depth (for example, a depth of about 30 nm) toward the substrate 1. Further, the "upper surface of the KNN film 3" refers to one of the two main surfaces of the KNN film 3, the surface on the top electrode film 4 side, i.e., the surface that serves as the base for the top electrode film 4 (or the top adhesive layer 7, when the piezoelectric stack 10 has the top adhesive layer 7 described below). Further, the "upper surface of the KNN film 3" is the same surface as the upper surface of the outermost layer of the KNN film 3. Therefore, hereinafter, the "upper surface of the outermost layer of the KNN film 3" will also be referred to as the "upper surface of the KNN film 3."

The KNN film 3 in this aspect has a flat upper surface, even though it is a film having a high percentage of the area rate of the (110) and the (111) on its upper surface. These points will be described later.

The top electrode film 4 is deposited on the KNN film 3. The top electrode film 4 is mainly composed of, for example, various metals such as Pt, Au, Al, Cu, or alloys of these metals. The top electrode film 4 can be deposited by a method such as a sputtering method, a vapor deposition method, a plating method, or a metal paste application method. The top electrode film 4 does not have a large effect on the crystal structure of the KNN film 3 as the bottom electrode film 2 does. Therefore, there is no particular limitation in the material, crystalline structure, and deposition method of the top electrode film 4. The top adhesive layer 7 is provided between the KNN film 3 and the top electrode film 4 to improve adhesion therebetween. The top adhesive layer 7 can be formed using a metal oxide such as RuO₂, IrO₂, TiO₂, SRO, or LNO. The thickness of the top electrode film 4 can be, for example, 50 nm or more and 5000 nm or less, preferably 50 nm or more and 300 nm or less, and the thickness of the top adhesive layer 7 can be, for example, 1 nm or more and 200 nm or less, preferably 5 nm or more and 50 nm or less.

As described above, in the KNN film 3 in this aspect, the percentage of the area rate of the (110) and the (111) on the upper surface is more than 10% and 70% or less.

Here, the "percentage of the area rate of the (110) and the (111)" is a value calculated by the following (Equation 1) using the results of measuring the crystal orientation on the upper surface of the KNN film 3 by the electron backscatter diffraction (EBSD) method and calculating the area rate of the (001), the (110), and the (111), respectively. That is, the "percentage of the area rate of the (110) and the (111)" is the percentage of the total area rate of the (110) and the (111) with respect to the total area rate of the (001), the (110) and the (111) on the upper surface of the KNN film 3. In the following description, the percentage of the area rate of the (110) and the (111) on the upper surface of the KNN film 3 will also be referred to as a hetero-oriented rate. Also, in the following description, the "KNN film 3 having a hetero-oriented rate of more than 10% and 70% or less" will also be referred to as a "highly hetero-oriented KNN film 3." 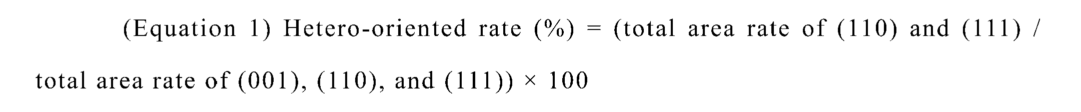 Hetero-oriented rate (%) = (total area rate of (110) and (111) / total area rate of (001), (110), and (111)) × 100 (Equation 1)

There are cases such that the KNN film 3 in this aspect contains (111) KNN crystals but not contains (110) KNN crystals, contains (110) KNN crystals but not contains (111) KNN crystals, or contains both (110) KNN crystals and (111) KNN crystals, in its outermost layer.

The KNN film 3 in this aspect is a film having a good flatness on the upper surface, even though it is a highly hetero-oriented film. In this specification, "good flatness on the upper surface of the KNN film 3" means that the arithmetic mean roughness (Ra) and the root mean square roughness (RMS) on the upper surface of the KNN film 3 are small, and the upper surface of the KNN film 3 is flat. Further, in this specification, "poor flatness on the upper surface of the KNN film 3" means that the Ra and RMS values on the upper surface of the KNN film 3 are large and the upper surface of the KNN film 3 is not flat.

Specifically, in the KNN film 3, Ra of the upper surface is 8 nm or less and RMS of the upper surface is 12 nm or less, even though the hetero-oriented rate is more than 10% and 70% or less.

Here, Ra and RMS are values calculated in accordance with JIS B0601 (2001) from an upper surface profile (an atomic force microscope (AFM) image) of the KNN film 3, obtained by observing the upper surface of the KNN film 3 using AFM. RMS is also referred to as a root mean square height (Rq). The same applies to Ra2 and RMS2, which will be described later.

Further, in this specification, "Ra on the upper surface" means an average value of Ra calculated in multiple different regions (e.g., 5 µm × 5 µm regions) of the upper surface of the KNN film 3, and hereinafter, "Ra on the upper surface" will also be referred to as Ra1. Also, in this specification, "RMS on the upper surface" means an average value of RMS (Rq) calculated in multiple different regions (e.g., 5 µm × 5 µm regions) of the upper surface of the KNN film 3, and hereinafter, "RMS on the upper surface" will also be referred to as RMS1.

By ensuring that Ra1 is 8 nm or less and RMS1 is 12 nm or less, an occurrence of local electric field concentration in the highly hetero-oriented KNN film 3 can be suppressed, and further, an occurrence of a starting point for dielectric breakdown can be suppressed. As a result, the dielectric strength of the highly hetero-oriented KNN film 3 can be improved.

When the hetero-oriented rate is more than 70%, it may not be possible to achieve Ra1 of 8 nm or less and RMS1 of 12 nm or less in some cases.

Further, when Ra1 is more than 8 nm or RMS1 is more than 12 nm, the occurrence of local electric field concentration in the highly hetero-oriented KNN film 3 may not be sufficiently suppressed in some cases. As a result, the dielectric strength of the highly hetero-oriented KNN film 3 may not be improved sufficiently in some cases.

Preferably, Ra1 is, for example, 1.5 nm or more, and RMS1 is, for example, 2 nm or more. This allows to suppress a decrease in adhesion between the KNN film 3 and the top electrode film 4. That is, in the highly hetero-oriented KNN film 3, the decrease in adhesion between the KNN film 3 and the top electrode film 4 can be suppressed while suppressing the occurrence of local electric field concentration.

When Ra1 is less than 1.5 nm or RMS1 is less than 2 nm, the adhesion between the KNN film 3 and the top electrode film 4 may decrease in some cases.

Conventionally, it has been known that the (111) KNN crystal or the (110) KNN crystal has a larger unevenness height on the surface than the (001) KNN crystal. Therefore, the higher the hetero-oriented rate of the KNN film 3, the more likely it is that the flatness on the upper surface of the KNN film 3 will be poor. In contrast, the KNN film 3 in this aspect is a film having a good flatness on the upper surface, even though it is a highly hetero-oriented film, as described above.

It is also known that the (111) KNN crystal grows in a triangular pyramidal shape and has a larger unevenness height on the surface than the (110) KNN crystal. Therefore, when the KNN film 3 contains (111) KNN crystals in its outermost layer, the flatness on the upper surface becomes poorer than the case where the KNN film 3 does not contain (111) KNN crystals in its outermost layer. Further, in the KNN film 3, the higher the area rate of the (111) on the upper surface, the poorer the flatness on the upper surface tends to be. In contrast, in the KNN film 3 in this aspect, Ra1 is 8 nm or less and RMS1 is 12 nm or less even though its outermost layer contains (111) KNN crystals. Further, Ra1 is 8 nm or less and RMS1 is 12 nm or less even though the area rate of the (111) on the upper surface of the KNN film 3 in this aspect is more than 10% for example.

However, due to the (111) KNN crystal having a large unevenness height on the surface, when the area rate of the (111) on the upper surface of the KNN film 3 is more than 30%, the flatness on the upper surface may be poor in some cases. Therefore, it is preferable that the area rate of the (111) on the upper surface of the KNN film 3 is, for example, 30% or less. Thus, it is possible to reliably achieve Ra1 of 8 nm or less and RMS1 of 12 nm or less, even though the KNN film 3 is a highly hetero-oriented film.

It is also known that the (110) KNN crystal grows in a frustum shape and has a smaller unevenness height on the surface than the (111) KNN crystal. Therefore, by ensuring that the KNN film 3 in this aspect contains (110) KNN crystals in its outermost layer, it is possible to easily and reliably achieve Ra1 of 8 nm or less and RMS1 of 12 nm or less, even though the KNN film 3 is a highly hetero-oriented film. Also, by ensuring that the KNN film 3 contains (110) KNN crystals in its outermost layer, it is possible to reliably achieve Ra1 of 8 nm or less and RMS1 of 12 nm or less, even though the hetero-oriented rate is more than 30%.

Further, by ensuring that the area rate of the (110) on the upper surface of the KNN film 3 is, for example, 30% or more, it is possible to reliably achieve Ra1 of 8 nm or less and RMS1 of 12 nm or less, even though the hetero-oriented rate is 30% or more and 70% or less. Also, by ensuring that the area rate of the (110) on the upper surface of the KNN film 3 is, for example, 50% or more, it is possible to reliably achieve Ra1 of 8 nm or less and RMS1 of 12 nm or less, even though the hetero-oriented rate is 50% or more and 70% or less, or even 60% or more and 70% or less.

Further, when the KNN film 3 is deposited by a sputtering method, the unevenness height on the surface of the (111) KNN crystal or (110) KNN crystal tends to be larger than when the film is deposited by a liquid phase method such as a sol-gel method. Therefore, the higher the hetero-orientation rate of the KNN film deposited by the sputtering method, the poorer the flatness on the upper surface becomes compared to the KNN film deposited by the liquid phase method. In contrast, the KNN film 3 in this aspect is deposited, for example, while rotating the substrate 1, as will be described later. Therefore, in this aspect, Ra1 can be 8 nm or less and RMS1 can be 12 nm or less, even though the KNN film 3 is a highly hetero-oriented film deposited by a sputtering method, etc. Further, in this aspect, Ra1 can be 8 nm or less and RMS1 can be 12 nm or less without applying treatment such as polishing or etching to the highly hetero-oriented KNN film 3 deposited by a sputtering method, etc., (in the as-deposited state).

Preferably, Ra is, for example, 6 nm or less and RMS is, for example, 8 nm or less over the entire upper surface of the KNN film 3.

Specifically, as shown in Fig. 2, when a region 3b of the upper surface of the KNN film 3, excluding an outer peripheral region 3a, is divided into a plurality of regions of a predetermined size, and each of the regions is set as an observation visual field 40, and the upper surface of the KNN film 3 is observed by AFM for each of the observation visual fields 40, and Ra and RMS of the upper surface of the KNN film 3 are calculated from the obtained AFM image, then, Ra is, for example, 6 nm or less, and RMS is, for example, 8 nm or less, in 80% or more visual fields 40 out of all the observation visual fields 40 (total number of the observation visual fields 40).

Here, the "outer peripheral region 3a on the upper surface of the KNN film 3" refers to a region on the upper surface of the KNN film 3, that has a predetermined width from the outer peripheral edge toward the center (for example, a region ranging from the outer peripheral edge toward the center by up to 5 mm). The size of one observation visual field 40 is, for example, 5 µm × 5 µm. The same applies to Rz, which will be described later.

Further, "Ra in the observation visual field 40" is a value obtained by observing the upper surface of the KNN film 3 in one observation visual field 40 using AFM and calculating Ra from the obtained AFM image. Hereinafter, "Ra in (one) observation visual field 40" will also be referred to as Ra2. Also, "RMS in the observation visual field 40" is a value obtained by observing the upper surface of the KNN film 3 in one observation visual field 40 using AFM and calculating the RMS from the obtained AFM image. Hereinafter, "RMS in (one) observation visual field 40" will also be referred to as RMS2.

By ensuring that Ra2 and RMS2 are each below a predetermined value in, for example, 80% or more visual fields 40 out of all the observation visual fields 40, variation in dielectric strength can be suppressed among multiple piezoelectric device modules 30 (described below) fabricated from a single piezoelectric stack 10. As a result, variation in performance among multiple piezoelectric device modules 30 obtained from a single piezoelectric stack 10 can be suppressed.

When the number of observation visual fields 40 in which Ra2 and RMS2 are below a predetermined value is less than 80% of all the observation visual fields 40, it may sometimes not be possible to suppress variation in performance among multiple piezoelectric device modules 30 obtained from a single piezoelectric stack 10.

Also, by ensuring that Ra2 is, for example, 6 nm or less and RMS2 is, for example, 8 nm or less in, for example, 80% or more visual fields 40 out of all the observation visual fields 40, it is possible to reliably achieve Ra1 of 8 nm or less and RMS1 of 12 nm or less, even though the KNN film 3 is a highly hetero-oriented film. Further, in each of the multiple piezoelectric device modules 30 obtained from a single piezoelectric stack 10, the occurrence of local electric field concentration can be reliably suppressed. As a result, the dielectric strength of each of the multiple piezoelectric device modules 30 can be reliably improved.

Preferably, Ra2 is, for example, 1.5 nm or more, and RMS2 is, for example, 2 nm or more. Thus, a decrease in adhesion between the KNN film 3 and the top electrode film 4 can be suppressed over the entire upper surface of the KNN film 3. That is, the occurrence of local electric field concentration can be suppressed, while reliably suppressing a decrease in adhesion between the KNN film 3 and the top electrode film 4 over the entire upper surface of the highly hetero-oriented KNN film 3.

When Ra2 is less than 1.5 nm or RMS2 is less than 2 nm, the adhesion between the KNN film 3 and the top electrode film 4 may decrease in some cases.

Preferably, a maximum roughness (Rz) in height is, for example, 30 nm or more and 160 nm or less, over the entire upper surface of the KNN film 3.

Specifically, as shown in Fig. 2, when the region 3b of the upper surface of the KNN film 3, excluding the outer peripheral region 3a, is divided into a plurality of regions of a predetermined size, and each of the regions is set as an observation visual field 40, and the upper surface of the KNN film 3 is observed using AFM for each of the observation visual fields 40 and Rz of the upper surface of the KNN film 3 is calculated from the obtained AFM image, then, Rz is, for example, 30 nm or more and 160 nm or less, in, for example, 80% or more visual fields 40 out of all the visual fields 40 (total number of the visual fields 40).

Here, Rz is a value calculated in accordance with JIS B0601 (2001) from an upper surface profile (AFM image) of the KNN film 3, obtained by observing the upper surface of the KNN film 3 using AFM. Further, "Rz in the observation visual field 40" is a value calculated from an AFM image obtained by observing the upper surface of the KNN film 3 in one observation visual field 40, using AFM.

By ensuring that Rz is within a specified range in, for example, 80% or more visual fields 40 out of all the observation visual fields 40, it is possible to reliably suppress variation in performance such as dielectric strength among multiple piezoelectric device modules 30 (described below) obtained from a single piezoelectric stack 10.

When the number of observation visual fields 40 in which the Rz value is within a predetermined range is less than 80% of all the observation visual fields 40, it may not be possible to suppress the variation in performance among multiple piezoelectric device modules 30 obtained from a single piezoelectric stack 10.

Also, by ensuring that Rz is, for example, 30 nm or more in, for example, 80% or more visual fields 40 out of all the observation visual fields 40, it is possible to reliably suppress a decrease in adhesion between the KNN film 3 and the top electrode film 4 over the entire upper surface of the KNN film 3. That is, the occurrence of local electric field concentration can be suppressed, while more reliably suppressing the decrease in adhesion between the KNN film 3 and the top electrode film 4 over the entire upper surface of the highly hetero-oriented KNN film 3.

Also, by ensuring that Rz is, for example, 160 nm or less in, for example, 80% or more visual fields 40 out of all the observation visual fields 40, it is possible to more reliably achieve Ra1 of 8 nm or less and RMS1 of 12 nm or less, even though the KNN film 3 is a highly hetero-oriented film. Preferably, Rz is, for example, 130 nm or less in, for example, 80% or more visual fields 40 out of all the observation visual fields 40. Thus, it is possible to further reliably achieve Ra1 of 8 nm or less and RMS1 of 12 nm or less, even though the KNN film 3 is a highly hetero-oriented film.

### (2) A method for manufacturing the piezoelectric stack, piezoelectric element, and piezoelectric device module

A method for manufacturing the above-described piezoelectric stack 10, piezoelectric element, and piezoelectric device module will be described.

### (Deposition of the bottom adhesive layer and the bottom electrode film)

First, the substrate 1 is prepared, and the bottom adhesive layer 6 (e.g., ZnO layer) and the bottom electrode film 2 (e.g., Pt film) are deposited in this order on one of the main surfaces of the substrate 1 by, for example, a sputtering method. It is also acceptable to prepare the substrate 1 with the bottom adhesive layer 6 and the bottom electrode film 2 deposited in advance on either of its main surfaces.

The conditions for depositing the ZnO layer as the bottom adhesive layer 6 are exemplified as follows. The deposition time for the bottom adhesive layer 6 is adjusted appropriately depending on a target thickness of the bottom adhesive layer 6.
Target: ZnO sintered ceramics
Temperature (substrate temperature): 200 °C or more and 700 °C or less, preferably 300 °C or more and 700 °C or less, more preferably 500 °C or more and 700 °C or less
Applied power (power density): 2 W/cm² or more and 6 W/cm² or less, preferably 3 W/cm² or more and 5 W/cm² or less
Atmosphere: mixed gas atmosphere of argon (Ar) gas and oxygen (O₂) gas (hereinafter also referred to as "Ar/O₂ mixed gas atmosphere")
Partial pressure ratio of Ar gas to O₂ gas (Ar gas partial pressure/O₂ gas partial pressure): 5/1 to 30/1, preferably 7/1 to 20/1, more preferably 10/1 to 15/1
Atmospheric pressure: 0.1 Pa or more and 0.5 Pa or less, preferably 0.2 Pa or more and 0.4 Pa or less
Thickness: 1 nm or more and 200 nm or less, preferably 10 nm or more and 50 nm or less

In this specification, when a numerical range is expressed, such as "5/1 to 30/1," it means that a lower limit and an upper limit are included in this range. The same applies to other numerical ranges.

The conditions for depositing a Ti layer, etc., as the bottom adhesive layer 6 are exemplified as follows.
Target: Ti plate, etc.
Temperature (substrate temperature): 100 °C or more and 500 °C or less, preferably 200 °C or more and 400 °C or less
Atmosphere: Ar gas atmosphere
Atmospheric pressure: 0.1 Pa or more and 0.5 Pa or less, preferably 0.2 Pa or more and 0.4 Pa or less
Other conditions can be similar to those for depositing the ZnO layer.

The conditions for depositing the Pt film as the bottom electrode film 2 are exemplified as follows. The deposition time for the bottom electrode film 2 is adjusted appropriately depending on a target thickness of the bottom electrode film 2.
Target: Pt plate
Temperature (substrate temperature): 200 °C or more and 600 °C or less, preferably 300 °C or more and 500 °C or less
Applied power (power density): 1 W/cm² or more and 5 W/cm² or less, preferably 2 W/cm² or more and 4 W/cm² or less
Atmosphere: Ar gas atmosphere
Atmospheric pressure: 0.1 Pa or more and 0.5 Pa or less, preferably 0.2 Pa or more and 0.4 Pa or less
Thickness: 100 nm or more and 400 nm or less

### (Deposition of the KNN film)

After the deposition of the bottom adhesive layer 6 and the bottom electrode film 2 is completed, the KNN film 3 is then deposited on the bottom electrode film 2 by a sputtering method such as a RF magnetron sputtering method. The composition of the KNN film 3 can be adjusted by controlling the composition of a target used during sputtering deposition, for example. The target can be fabricated by mixing K₂CO₃ powder, Na₂CO₃ powder, Nb₂O₅ powder, etc., and firing the mixture. The composition of the target can be controlled by adjusting the mixing ratio of K₂CO₃ powder, Na₂CO₃ powder, Nb₂O₅ powder, etc. When depositing the KNN film 3 containing the above-described elements such as Cu and Mn, a target in which Cu powder (or CuO powder), Mn powder (or MnO powder), etc., are mixed in a predetermined ratio in addition to the above-described powders, may be used.

The conditions for depositing the KNN film 3 are exemplified as follows. The deposition time for the KNN film 3 is adjusted appropriately depending on a target thickness of the KNN film 3.
Temperature (substrate temperature): 900 °C or more, preferably 900 °C or more and 1050 °C or less, more preferably 950 °C or more and 1000 °C or less Atmosphere: Ar/O₂ mixed gas atmosphere
Partial pressure ratio of O₂ gas to Ar gas (O₂ gas partial pressure/Ar gas partial pressure): 0 to 1/20, preferably 0 to 1/30
Atmospheric pressure (chamber pressure): 0.05 Pa or less, preferably 0.03 Pa or more and 0.05 Pa or less
Substrate rotation speed: 300 rpm or more and 1000 rpm or less, preferably 500 rpm or more and 1000 rpm or less
RF power density: 2.7 W/cm² or more and 4.1 W/cm² or less, preferably 2.8 W/cm² or more and 3.8 W/cm² or less
Deposition rate: 0.5 µm/h or more and 4 µm/h or less, preferably 0.5 µm/h or more and 2 µm/h or less
Thickness: 0.5 µm or more and 5 µm or less, preferably 1 µm or more and 3 µm or less

"O₂ gas partial pressure/Ar gas partial pressure is 0 (zero)" means a state in which the O₂ gas partial pressure is 0, that is, a case of an only Ar gas atmosphere.

By depositing the KNN film 3 under the above conditions, the KNN film 3 having good flatness on the upper surface can be obtained, even though the KNN film 3 is a highly hetero-oriented film.

Particularly, by depositing the KNN film 3 while rotating the substrate 1 (on which the bottom electrode film 2, etc., has been deposited) at a rotation speed within a range of 300 rpm or more and 1000 rpm or less, it is possible to appropriately suppress the growth of (110) KNN crystals or (111) KNN crystals in the thickness direction of the KNN film 3. As a result, the KNN film 3 in which Ra1 is 8 nm or less and RMS1 is 12 nm or less (in the as-deposited state) can be obtained even though the hetero-oriented rate is more than 10% and 70% or less.

When the rotation speed of the substrate 1 is less than 300 rpm, the growth of the (110) KNN crystals or the (111) KNN crystals in the thickness direction of the KNN film 3 is not sufficiently suppressed. Therefore, the upper surface cannot be sufficiently flat, resulting in Ra1 of more than 8 nm, and the RMS1 of more than 12 nm in the highly hetero-oriented KNN film 3.

By ensuring that the rotation speed of the substrate 1 is 300 rpm or more, it becomes possible to properly suppress the growth of the (110) KNN crystals or (111) KNN crystals in the thickness direction of the KNN film 3. As a result, Ra1 can be 8 nm or less and RMS1 can be 12 nm or less in the highly hetero-oriented KNN film 3. Preferably, the rotation speed of the substrate 1 is, for example, 500 rpm or more. This allows to more appropriately suppress the growth of the (110) KNN crystals or (111) KNN crystals in the thickness direction of the KNN film 3. As a result, it is possible to reliably achieve Ra1 of 8 nm or less and RMS1 of 12 nm or less in the highly hetero-oriented KNN film 3. It is also possible to set the values of Ra1 and RMS1 to be small.

However, when the rotation speed of the substrate 1 is more than 1000 rpm, Ra1 and RMS1 of the KNN film 3 may become excessively small in some cases. Further, the difference between the peripheral speed at the rotation center region of the substrate 1 and the peripheral speed at the outer peripheral region of the substrate 1 during deposition of the KNN film 3 becomes excessively large. This results in a difference in flatness on the upper surface of the KNN film 3 between the center region and the outer peripheral region of the KNN film 3. As described above, Ra1 and RMS1 are the average values of Ra and RMS calculated in the multiple different regions on the upper surface of the KNN film 3, respectively. Therefore, when there is a difference in flatness on the upper surface of the KNN film 3 between the center region and the outer peripheral region, Ra1 and RMS1 become large. As a result, in the highly hetero-oriented KNN film 3, Ra1 may be more than 8 nm, and the RMS1 may be more than 12 nm in some cases.

By ensuring that the rotation speed of the substrate 1 is 1000 rpm or less, the difference between the peripheral speed of the center region of the substrate 1 and the peripheral speed of the outer peripheral region of the substrate 1 can be prevented from becoming excessively large during deposition of the KNN film 3. As a result, in the highly hetero-oriented KNN film 3, Ra1 can be 8 nm or less, and RMS1 can be 12 nm or less.

Further, by ensuring that the KNN film 3 is deposited under the above-described conditions, the KNN film 3 with good flatness on the upper surface can be obtained, even though the KNN film 3 contains (111) KNN crystals in the outermost layer. For example, Ra1 can be 8 nm or less and RMS1 can be 12 nm or less, even though the area rate of the (111) on the upper surface is more than 10%, or even more than 10% and 30% or less.

Further, by ensuring that the KNN film 3 is deposited under the above-described conditions, the KNN film 3 with good flatness on the upper surface can be obtained, even though the KNN film 3 contains (110) KNN crystals in the outermost layer. For example, Ra1 can be 8 nm or less and RMS1 can be 12 nm or less, even though the hetero-oriented rate is more than 30%. Further, for example, Ra1 can be 8 nm or less and RMS1 can be 12 nm or less, even though the area rate of the (110) on the upper surface is more than 10%.

Further, by ensuring that the KNN film 3 is deposited under the above-described conditions, Ra1 can be 8 nm or less and RMS1 can be 12 nm or less, even though the area rate of the (110) on the upper surface is 30% or more and the hetero-oriented rate is 30% or more and 70% or less. Further, Ra1 can be 8 nm or less and RMS1 can be 12 nm or less, even though the area rate of the (110) on the upper surface is 50% or more and the hetero-oriented rate is 50% or more and 70% or less, or even 60% or more and 70% or less.

Further, when the substrate 1 is rotated at a high speed to deposit the KNN film 3, the difference between the peripheral speed at the rotation center region of the substrate 1 and the peripheral speed at the outer peripheral region of the substrate 1, which occurs when the substrate 1 is rotated, is preferably adjusted so as to appropriately cancel out. For example, in-plane temperature distribution of the substrate 1 is adjusted by a temperature adjusting unit such as a heater so that the in-plane temperature of the substrate 1 gradually increases toward the center of rotation of the substrate 1. This allows to alleviate in a balanced manner the tendency for the flatness on the rotation center region to be poorer than that of the outer peripheral region, so that the flatness on the center region of the KNN film 3 can be equal to the flatness on the outer peripheral region of the KNN film 3. As a result, Ra2 can be, for example, 6 nm or less, and RMS2 can be, for example, 8 nm or less, over the entire upper surface of the highly hetero-oriented KNN film 3. Also, Rz can be, for example, 30 nm or more and 160 nm or less, over the entire upper surface of the highly hetero-oriented KNN film 3.

### (Deposition of the top adhesive layer and top electrode film)

After the deposition of the KNN film 3 is completed, the top adhesive layer 7 (e.g., RuO₂ layer) and the top electrode film 4 (e.g., Pt film) are deposited in this order on the KNN film 3 by, for example, a sputtering method.

The conditions for depositing a RuO₂ layer, etc., as the top adhesive layer 7 are exemplified as follows. The deposition time for the top adhesive layer 7 is adjusted appropriately depending on a target thickness of the top adhesive layer 7.
Target: Ru plate, etc.
Temperature (substrate temperature): Room temperature (25 °C) or more and 500 °C or less
Applied power (power density): 0.3 W/cm² or more and 2 W/cm² or less, preferably 0.5 W/cm² or more and 1 W/cm² or less
Atmosphere: Ar/O₂ mixed gas atmosphere
Partial pressure ratio of Ar gas to O₂ gas (Ar gas partial pressure/O₂ gas partial pressure): 3/5 to 1/1, preferably 3/4 to 1/1
Atmospheric pressure: 0.1 Pa or more and 1.0 Pa or less, preferably 0.2 Pa or more and 0.7 Pa or less
Thickness: 1 nm or more and 200 nm or less, preferably 5 nm or more and 50 nm or less

The conditions for depositing the Pt film, etc., as the top electrode film 4 are exemplified as follows. The deposition time for the top electrode film 4 is adjusted appropriately depending on a target thickness of the top electrode film 4.
Target: Pt plate, etc.
Temperature (substrate temperature): Room temperature (25 °C) or more and 500 °C or less
Applied power (power density): 1 W/cm² or more and 5 W/cm² or less, preferably 2 W/cm² or more and 4 W/cm² or less
Atmosphere: Ar gas atmosphere
Atmosphere pressure: 0.1 Pa or more and 0.5 Pa or less, preferably 0.2 Pa or more and 0.4 Pa or less
Thickness: 50 nm or more and 5000 nm or less, preferably 50 nm or more and 300 nm or less

As described above, by depositing the bottom adhesive layer 6, the bottom electrode film 2, the KNN film 3, the top adhesive layer 7, and the top electrode film 4 in this order, the piezoelectric stack 10 shown in Fig. 1 is obtained.

### (Fabrication of a piezoelectric element)

After the piezoelectric stack 10 shown in Fig. 1 is fabricated, the piezoelectric stack 10 is processed to form an element having the KNN film 3 (also referred to as a piezoelectric element 20).

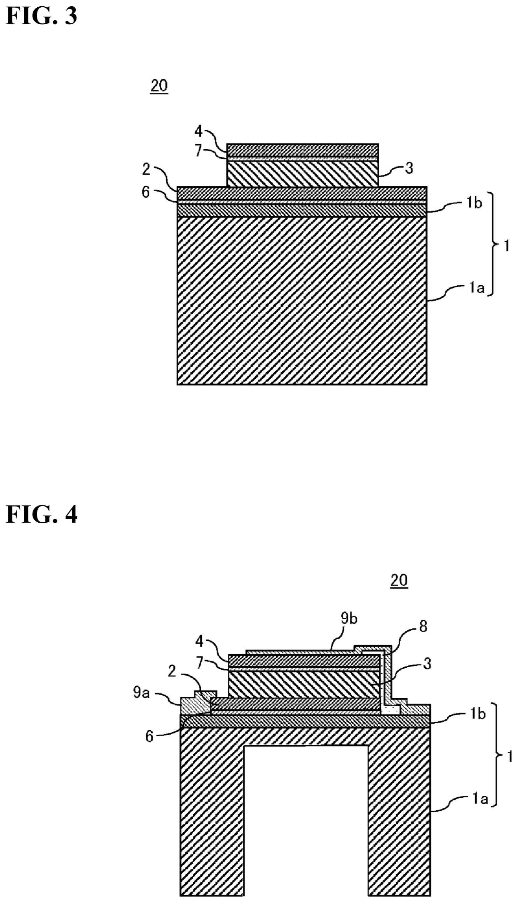

Specifically, first, the top electrode film 4 (including the top adhesive layer 7) and the KNN film 3 are individually patterned by dry etching using, for example, Ar gas or reactive gas. In the patterning, the top electrode film 4 (including the top adhesive layer 7) and the KNN film 3 are each formed into a predetermined shape, and a part of the bottom electrode film 2 is exposed. In the patterning, a photoresist can be used as an etching mask. Fig. 3 shows the piezoelectric stack 10 after patterning, that is, shows the piezoelectric element 20. The piezoelectric element 20 shown in Fig. 3 is also referred to as a simplified piezoelectric element.

After the simplified piezoelectric element as shown in Fig. 3 is fabricated, the bottom electrode film 2 and the bottom adhesive layer 6 are each patterned by dry etching using, for example, Ar gas or reactive gas, to form the bottom electrode film 2 and the bottom adhesive layer 6 into a predetermined shape. In this patterning, a photoresist can be used as an etching mask.

After the patterning of the bottom electrode film 2 and the bottom adhesive layer 6 is completed, an insulating film 8 and metal wirings 9a and 9b are provided. Specifically, first, a layer composed of an insulating material is provided from the top electrode film 4 to the substrate 1 so as to cover the side surface of the KNN film 3, and a layer composed of the insulating material is patterned by dry etching using reactive gas such as Ar gas or CF₄ gas, etc., or by wet etching, to thereby provide the insulating film 8. The insulating film 8 can be formed using an oxide such as silicon oxide (SiO₂), aluminum oxide (Al₂O₃), or tantalum oxide (Ta₂O₅). The insulating film 8 may be a single layer film or a stack of multiple layers. The insulating film 8 can be provided by a method such as a CVD method or a sputtering method.

After the insulating film 8 is provided, a layer composed of a material containing metal (metal wiring layer) is provided. Then, the metal wiring layer is patterned by dry etching using Ar gas or reactive gas, or by wet etching, to form metal wirings 9a and 9b. The metal wiring 9a is formed (patterned) so as to be connected to (in contact with) the bottom electrode film 2 but not connected to (in contact with) the top electrode film 4, and the metal wiring 9b is formed so as to be connected to the top electrode film 4 but not connected to the bottom electrode film 2. The metal wirings 9a and 9b can be formed using various metals such as Au, Al, Ti, and Cr, etc., or alloys containing these metals as main components. The metal wirings 9a and 9b may be a single layer film or a stack of multiple layers. The metal wirings 9a and 9b (metal wiring layers) can be provided by a method such as a sputtering method, a vapor deposition method, a plating method, or a metal paste application method.

Further, a part of the substrate 1 is removed from the rear surface side of the substrate 1 (one of the two main surfaces of the substrate 1, that is, the surface on the opposite side to the surface on which the bottom electrode film 2, etc., are deposited) by Deep-RIE or wet etching. Thus, the piezoelectric element 20 having a membrane structure, a cantilever structure, etc., for example, a membrane-type MEMS piezoelectric element 20 as shown in Fig. 4, is obtained.

The etching conditions for patterning when forming the insulating film 8 and the metal wirings 9a, 9b, and the etching conditions for the substrate 1 when processing the piezoelectric stack 10 into the piezoelectric element 20 can be general etching conditions used in a semiconductor device manufacturing process, as long as the conditions do not deteriorate the insulating properties of the KNN film 3.

### (Fabrication of a piezoelectric device module)

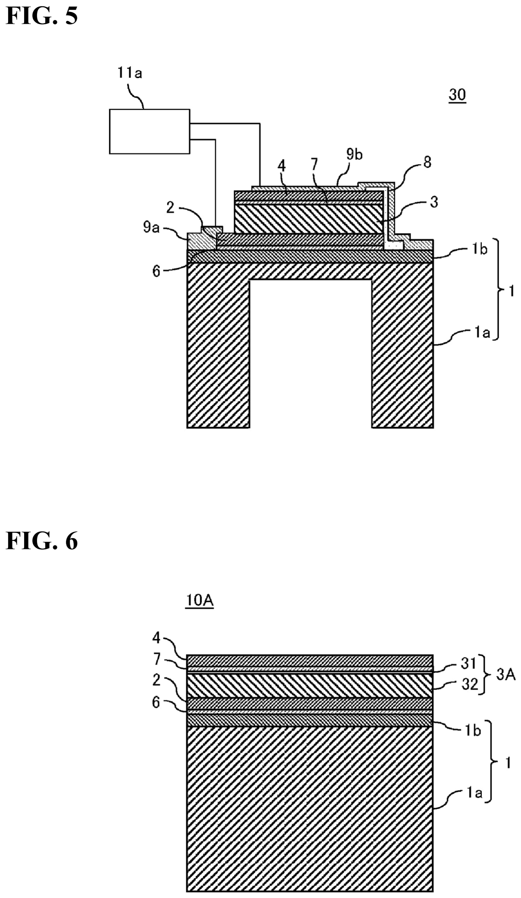

By connecting the voltage application means 11a to the obtained piezoelectric element 20, a device module 30 having the KNN film 3 (hereinafter also referred to as a piezoelectric device module 30) is obtained. Fig. 5 shows a schematic configuration view of the piezoelectric device module 30 according to this aspect. The piezoelectric device module 30 includes at least the piezoelectric element 20 and the voltage application means 11a connected to the piezoelectric element 20. The voltage application means 11a is a means that applies a voltage between the bottom electrode film 2 and the top electrode film 4 (between the electrodes). As the voltage application means 11a, various known means can be used.

By connecting the voltage application means 11a between the bottom electrode film 2 and the top electrode film 4 of the piezoelectric element 20, the piezoelectric device module 30 can function as an actuator. By applying a voltage between the bottom electrode film 2 and the top electrode film 4 by the voltage application means 11a, the KNN film 3 can be deformed. Due to this deformation action, various structures connected to the piezoelectric device module 30 can be actuated. In this case, examples of applications of the piezoelectric device module 30 include a head for an inkjet printer, a MEMS mirror for an optical scanner, and a vibrator for an ultrasonic generator.

### (3) Effects

According to this aspect, one or more of the following effects can be obtained.
(a) The flatness on the upper surface is good even though the KNN film 3 is a highly hetero-oriented film, that is, Ra1 is 8 nm or less and RMS1 is 12 nm or less even though the hetero-oriented rate is more than 10% and 70% or less. This allows to suppress the occurrence of local electric field concentration in the highly hetero-oriented KNN film 3. Therefore, the dielectric strength of the highly hetero-oriented KNN film 3 can be improved. As a result, even in the case of the highly hetero-oriented KNN film 3, it can be suitably used in applications such as actuators that require high breakdown voltage.
(b) The area rate of the (111) on the upper surface of the KNN film 3 is 30% or less. This allows to reliably achieve Ra1 of 8 nm or less and RMS1 of 12 nm or less, even though the KNN film 3 is a highly hetero-oriented film.
(c) The KNN film 3 contains the (110) KNN crystals in its outermost layer. This allows to easily and reliably achieve Ra1 of 8 nm or less and RMS1 of 12 nm or less, even though the KNN film 3 is a highly hetero-oriented film. Also, the KNN film 3 contains the (110) KNN crystals in its outermost layer. This allows to reliably achieve Ra1 of 8 nm or less and RMS1 of 12 nm or less, even though the hetero-oriented rate is more than 30%.
(d) The area rate of the (110) on the upper surface of the KNN film 3 is for example 30% or more. This allows to reliably achieve Ra1 of 8 nm or less and RMS1 of 12 nm or less, even though the hetero-oriented rate is 30% or more and 70% or less. Also, the area rate of the (110) on the upper surface of the KNN film 3 is for example 50% or more. This allows to reliably achieve Ra1 of 8 nm or less and RMS1 of 12 nm or less, even though the hetero-oriented rate is 50% or more and 70% or less, or even 60% or more and 70% or less.
(e) Ra1 is preferably 1.5 nm or more, and RMS1 is preferably 2 nm or more. This allows to suppress a decrease in adhesion between the KNN film 3 and the top electrode film 4.
(f) Preferably, in 80% or more visual fields 40 out of all the observation visual fields 40, Ra2 is 6 nm or less and RMS2 is 8 nm or less. This allows to suppress the variation in performance such as dielectric strength among multiple piezoelectric device modules 30 obtained from a single piezoelectric stack 10. Further, in each of the multiple piezoelectric device modules 30 obtained from a single piezoelectric stack 10, the occurrence of local electric field concentration can be reliably suppressed, and as a result, the dielectric strength of each of the multiple piezoelectric device modules 30 can be reliably improved.
(g) Ra2 is preferably 1.5 nm or more, and RMS2 is preferably 2 nm or more. This allows to suppress a decrease in adhesion between the KNN film 3 and the top electrode film 4 over the entire upper surface of the KNN film 3.
(h) Preferably, Rz is 30 nm or more and 160 nm or less in 80% or more visual fields 40 out of all the observation visual fields 40 described above. This allows to reliably suppress the variation in performance such as dielectric strength among multiple piezoelectric device modules 30 obtained from a single piezoelectric stack 10, and allows to reliably suppress a decrease in adhesion between the KNN film 3 and the top electrode film 4 over the entire upper surface of the KNN film 3, and also allows to more reliably achieve Ra1 of 8 nm or less and RMS1 of 12 nm or less, even though the KNN film 3 is a highly hetero-oriented film.
(i) The KNN film 3 is deposited while rotating the substrate 1 under the condition that the rotation speed of the substrate is 300 rpm or more and 1000 rpm or less. This allows to obtain the KNN film 3 with a good flatness on the upper surface, even though the KNN film 3 is a highly hetero-oriented film. That is, the KNN film 3 is deposited while rotating the substrate 1 under the above conditions, and this allows to achieve Ra1 of 8 nm or less and RMS1 of 12 nm or less, even though the hetero-oriented rate is more than 10% and 70% or less.
(j) Preferably, when the substrate 1 is rotated to deposit the KNN film 3, the in-plane temperature distribution of the substrate 1 is adjusted by the temperature adjustment unit so that the in-plane temperature of the substrate 1 gradually increases toward the center of rotation of the substrate 1. This allows to improve the flatness over the entire upper surface of the KNN film 3. For example, it is possible to reliably achieve Ra2 of 6 nm or less, RMS2 of 8 nm or less, or Rz of 30 nm or more and 160 nm or less, over the entire upper surface of the highly hetero-oriented KNN film 3.

### (4) Modified Example

This aspect can be modified as follows. In the following description of the modified examples, the same components as those in the above aspect are designated by the same reference numerals, and the description thereof will be omitted. The above aspect and the following modified examples can be combined in any way.

The piezoelectric stack 10A according to this modified example includes a substrate 1, a bottom adhesive layer 6, a bottom electrode film 2, a KNN film 3A, a top adhesive layer 7, and a top electrode film 4. As shown in Fig. 6, the KNN film 3A of this modified example has a cap layer 31 that constitutes a region ranging from the upper surface of the KNN film 3A to a predetermined depth (e.g., a depth of 100 nm) toward the substrate 1, and a bulk layer 32 that constitutes a region other than the cap layer 31.

Similarly to the KNN film 3 described above, crystals constituting the outermost layer of the KNN film 3A in this modified example contain at least one of (110) KNN crystals and (111) KNN crystals. Further, in the KNN film 3A of this modified example, the upper surface is a flat film, even though the area rate of the (110) and the (111) on the upper surface is more than 10% and 70% or less.

Here, the "outermost layer of the KNN film 3A" refers to a region ranging from the upper surface of the cap layer 31 to a predetermined depth (e.g., a depth of about 30 nm) toward the substrate 1, and is a part of a region that constitutes the cap layer 31. Further, the "upper surface of the cap layer 31" is the same surface as the upper surface of the outermost layer of the KNN film 3A, and corresponds to the upper surface of the KNN film 3 in the above-described aspect. Therefore, hereinafter, "the upper surface of the outermost layer of the KNN film 3A" will also be referred to as "the upper surface of the cap layer 31."

The outermost layer and upper surface of the cap layer 31 have the same configuration as the outermost layer and upper surface of the KNN film 3 described in the above aspect, respectively. That is, in the cap layer 31, Ra (Ra1) of the upper surface is 8 nm or less and the RMS (RMS1) of the upper surface is 12 nm or less, even though the hetero-oriented rate is more than 10% and 70% or less. Preferably, Ra is, for example, 6 nm or less and RMS is, for example, 8 nm or less over the entire upper surface of the cap layer 31. Also preferably, Rz is, for example, 30 nm or more and 160 nm or less over the entire upper surface of the cap layer 31.

On the other hand, the hetero-oriented rate of the bulk layer 32 is similar to that of the cap layer 31. However, the flatness on the upper surface of the bulk layer 32 is poorer than that of the upper surface of the cap layer 31, and Ra of the upper surface is more than 8 nm and RMS of the upper surface is more than 12 nm. The "upper surface of the bulk layer 32" refers to one of the two main surfaces of the bulk layer 32, the surface on the cap layer 31 side, that is, the surface that serves as the base for the cap layer 31.

The deposition of the KNN film 3A includes a step of depositing the KNN film that constitutes the bulk layer 32 (bulk layer deposition step), and after the bulk layer deposition step, a step of depositing the KNN film that constitutes the cap layer 31 (cap layer deposition step).

The conditions in the bulk layer deposition step can be similar to those for depositing the KNN film 3 described in the above aspect, except that the rotation speed of the substrate 1 is set to less than 300 rpm. In the bulk layer deposition step, the rotation speed of the substrate 1 may be set to 0 rpm. "the rotation speed of the substrate 1 is set to 0 rpm" means that the KNN film is deposited without rotating the substrate 1.

The conditions for the cap layer deposition step can be similar to those for depositing the KNN film 3 described in the above aspect. That is, in the cap layer deposition step, the KNN film is deposited while rotating the substrate 1 at a rotation speed of 300 rpm or more and 1000 rpm or less.

The deposition times for the cap layer deposition step and the bulk layer deposition step are adjusted appropriately depending on a target thicknesses of the cap layer 31 and the bulk layer 32, respectively.

Thus, in this modified example, when depositing the KNN film 3A, the bulk layer deposition step in which the KNN film is deposited without rotating the substrate 1 and the cap layer deposition step in which the KNN film is deposited while rotating the substrate 1, are performed in this order.

In this modified example as well, in the cap layer deposition step, the KNN film is deposited while rotating the substrate 1 at a predetermined rotation speed, and this allows to appropriately suppress the growth of (110) KNN crystals or (111) KNN crystals in the thickness direction of the KNN film 3, and this allows to improve the flatness on the upper surface of the cap layer 31 having a high hetero-oriented rate. As a result, the cap layer 31 having Ra1 of 8 nm or less and RMS1 of 12 nm or less can be obtained, and eventually a highly hetero-oriented KNN film 3A, can be obtained, even though the hetero-oriented rate is more than 10% and less than 70%. Therefore, in this modified example as well, the same effects as those of the above-described aspect can be obtained.

### <Other Aspects>

As described above, one aspect of the present disclosure has been described. However, the present disclosure is not limited to the above aspect and can be modified in various ways without departing from the gist of the present disclosure. Further, these aspects can be combined arbitrarily.

For example, when the above-described piezoelectric stack 10 is formed into the piezoelectric element 20, the substrate 1 in the piezoelectric stack 10 may be replaced with another substrate, as long as the piezoelectric device module 30 fabricated using the piezoelectric stack 10 (piezoelectric element 20) can be used for a desired application such as a sensor or an actuator.

The above-described aspect shows an example in which one stack is formed on one substrate 1, but the present disclosure is not limited thereto. For example, multiple stacks may be formed on one substrate 1. In this case, each of the multiple stacks includes (the bottom adhesive layer 6,) the bottom electrode film 2, the KNN film 3, (the top adhesive layer 7,) and the top electrode film 4.

### Example

The following describes experimental results that support the effects of the above-described aspect.

### (Fabrication of Samples 1 to 9)

As the substrate, a Si substrate was prepared, the surface of which had a (100) orientation, a thickness of 610 µm, a diameter of 6 inches (15 cm), and a thermal oxide film (500 nm thickness) formed on the surface. Then, on the thermal oxide film of this Si substrate, a ZnO layer (25 nm thickness) as a bottom adhesive layer, a Pt film (preferentially oriented in the (111) direction with respect to the surface of the substrate, 200 nm thickness) as a bottom electrode film, and a KNN (polycrystalline) film (2 µm thickness) as a piezoelectric film were deposited in this order to fabricate Samples 1 to 9, which were piezoelectric stacks. In Samples 1 to 9, the bottom adhesive layer, the bottom electrode film, and the KNN film were all deposited by RF magnetron sputtering method under the conditions shown below. Further, in the fabrication of each sample, when the substrate is rotated during KNN film deposition, the in-plane temperature distribution of the substrate is adjusted, if necessary, using a temperature adjustment unit such as a heater so that the in-plane temperature of the substrate gradually increases toward the center of rotation of the substrate.

### <Conditions for depositing the ZnO layer as the bottom adhesion layer> Target: ZnO sintered ceramics

Substrate temperature: 500 °C
Applied power (power density): 4 W/cm²
Atmosphere: Ar/O₂ mixed gas atmosphere
Atmospheric pressure: 0.3 Pa
Ar gas partial pressure/O₂ gas partial pressure: 10/1
Deposition time: 3 minutes (25 nm thickness)

### <Conditions for depositing the Pt film as the bottom electrode film>

Target: Pt plate
Substrate temperature: 500 °C
Applied power (power density): 2 W/cm²
Atmosphere: Ar gas
Atmospheric pressure: 0.3 Pa
Deposition time: 14 minutes (200 nm thickness)

### <Conditions for depositing the KNN film>

Deposition temperature (substrate temperature): a predetermined temperature within a range of 900 °C or more and 1050 °C or less
Atmosphere: Ar/O₂ mixed gas
Atmospheric pressure: a predetermined pressure within a range of 0.05 Pa or less (0.03 Pa or more and 0.05 Pa or less)
O₂ gas partial pressure/Ar gas partial pressure: 1/20
Deposition time: 60 minutes (target thickness: 2000 nm (2 µm))
Substrate rotation speed: As shown in Table 1 below

**[Table 1]**

| Sample No. | Rotation speed (rpm) | Area rate of each crystal orientation (%) | | | Hetero-oriented rate (%) |
|---|---|---|---|---|---|
| | | (001) | (110) | (111) | (110)+(111) |
| 1 | 500 | 51.5 | 33.7 | 14.8 | 48.5 |
| 2 | 1000 | 45.4 | 41.9 | 12.7 | 54.6 |
| 3 | 1050 | 34.6 | 50.8 | 14.6 | 65.4 |
| 4 | 300 | 55.8 | 19.5 | 24.7 | 44.2 |
| 5 | 200 | 37.1 | 52.4 | 10.5 | 62.9 |
| 6 | 500 | 35.8 | 39.5 | 24.7 | 64.2 |
| 7 | 1000 | 32.2 | 42.6 | 25.2 | 67.8 |
| 8 | 500 | 65.3 | 25.4 | 9.3 | 34.7 |
| 9 | 500 | 87.2 | 8.4 | 4.4 | 12.8 |

### (Evaluation)

For each of the prepared samples, the hetero-oriented rate and the flatness on the upper surface of the KNN film were evaluated.

### <Evaluation of the hetero-oriented rate>

First, the crystal plane orientation on the upper surface of the KNN film of each sample was calculated using the following equipment, conditions, and method.
Equipment: Schottky field emission scanning electron microscope JSM-7800F Prime, manufactured by JEOL Co., Ltd., and DigiView IV slow scan CCD camera, manufactured by TSL Solutions Co., Ltd.
Analysis software: OIM Data Collection ver. 7. X, manufactured by TSL Solutions Co., Ltd., and OIM Analysis ver. 7. X, manufactured by TSL Solutions Co., Ltd.
Acceleration voltage: 15 kV
Irradiation current: 15 nA
Sample inclination: 70°
Magnification: 8000×
Measurement area: 9 µm × 9 µm
Measurement interval: 30 nm/step
Sample adjustment: Each sample was cleaved and was fixed to a sample stage for measurement using a conductive paste.
Analysis method: Crystal orientation was evaluated using EBSD method to create an inverse pole figure orientation map (tolerance angle: 0 to 5°) of the crystal plane orientation in the normal direction (ND) of the Si substrate in each sample. The area rate of each crystal orientation was measured from the inverse pole figure of the crystal plane orientation of each sample. In this case, crystal planes whose inclination from the normal direction of each crystal plane is within 0 to 5° were regarded as having the same orientation.

From the obtained data regarding the crystal plane orientation, the hetero-oriented rate of each sample was calculated based on the above equation 1. The calculation results are shown in Table 1 above.

### <Evaluation of the flatness on the upper surface of the KNN film>

First, an upper surface profile (AFM image) of the KNN film of each sample was obtained. Specifically, for each sample, the upper surface of the KNN film, excluding the outer peripheral region, was divided into a plurality of regions each having a size of 5 µm × 5 µm, as shown in Fig. 2, and each of the divided regions was set as an observation visual field. Then, the upper surface of each KNN film in all the observation visual fields was observed by AFM under the following conditions using the following equipment, and the upper surface profile (AFM image) of the KNN film in each observation visual field was obtained.
Equipment: Scanning probe microscope, model L-trace II, manufactured by Hitachi High-Tech Science Co. Ltd.
Observation area: 5 µm × 5 µm
Scanning pitch: 10 nm
Probe tip curvature radius: 10 nm or less

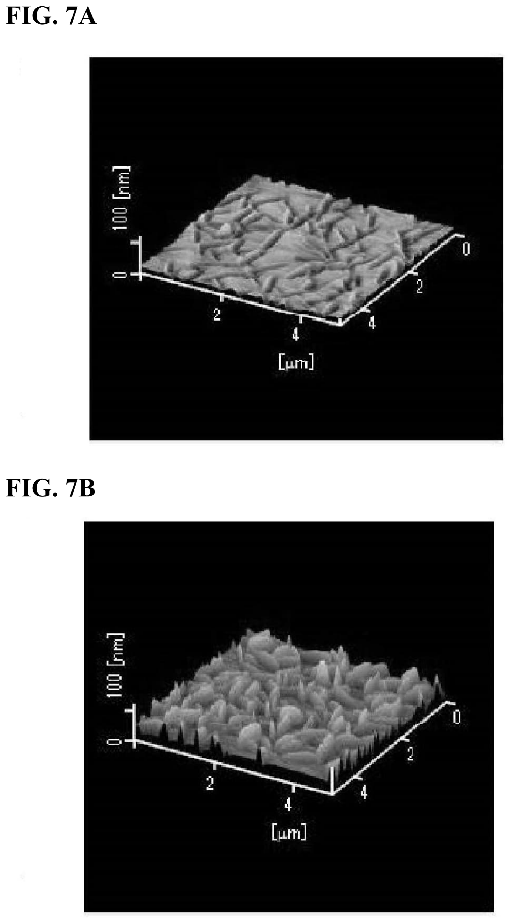

Fig. 7A is one example of the AFM image showing the upper surface portion of the KNN film in Sample 2, and Fig. 7B is one example of the AFM image showing the upper surface portion of the KNN film in Sample 5.

From the AFM images of Figs. 7A and 7B, it was confirmed that the flatness on the upper surface of the KNN film could be improved by depositing the KNN film while rotating the substrate at a rotation speed of 300 rpm or more.

Further, for each of the observation visual fields, Ra2 and RMS2 were calculated in accordance with JIS B0601 (2001), from the AFM images obtained in each observation visual field.

Then, for each sample, the percentage of visual fields in which Ra2 was 6 nm or less and RMS2 was 8 nm or less was calculated out of all the observation visual fields. The calculation results are shown in the "Result 1" column of Table 2 below. In the "Result 1" column, "○" means that the visual fields in which Ra2 was 6 nm or less and RMS2 was 8 nm or less occupies 80% or more visual fields out of all the observation visual fields, and "×" means that the visual fields in which Ra2 was 6 nm or less and RMS2 was 8 nm or less occupies less than 80% out of all the observation visual fields.

Further, for each sample, the percentage of the visual fields in which Rz was 30 nm or more and 160 nm or less out of all the observation visual fields was calculated. The calculation results are shown in the column "Result 2" in Table 2 below. In the column "Result 2," "○" means that the visual fields in which Rz was 30 nm or more and 160 nm or less occupies 80% or more out of all the observation visual fields, and "×" means that the visual fields in which Rz was 30 nm or more and 160 nm or less occupies less than 80% out of all the observation visual fields.

Further, for each of the observation visual fields, Rz was calculated in accordance with JIS B0601 (2001), from the AFM image obtained in each observation visual field. Then, in each sample, an average Rz value in all the observation visual fields was calculated. The calculation results are shown in the "Average Rz" column in Table 2 below.

Further, for each fabricated sample, average values of Ra2 and RMS2 in all the observation visual fields were calculated, and these average values were designated as Ra1 and RMS1. The calculation results are shown in Table 2 below.

### <Evaluation of adhesion>

A peeling test was performed to evaluate the adhesion between the KNN film (substrate) and the top adhesive layer (top electrode film). Specifically, first, on the KNN film of each prepared sample, a RuO₂ layer (30 nm thickness) as a top adhesive layer and a Pt film (100 nm thickness) as a top electrode film were deposited in this order. Both the top adhesive layer and the top electrode film were deposited by RF magnetron sputtering method under the conditions shown below.

### <Conditions for depositing the RuO₂ layer as the top adhesive layer>

Target: Ru plate
Substrate temperature: Room temperature (25 °C)
Applied power (power density): 0.5 W/cm²
Atmosphere: Ar/O₂ mixed gas atmosphere
Atmospheric pressure: 0.3 Pa
Ar gas partial pressure/O₂ gas partial pressure: 1/1
Deposition time: 20 minutes (30 nm thickness)

### <Conditions for depositing the Pt film as the top electrode film>

Target: Pt plate
Substrate temperature: Room temperature (25 °C)
Applied power (power density): 2 W/cm²
Atmosphere: Ar gas
Atmospheric pressure: 0.3 Pa
Deposition time: 7 minutes (100 nm thickness)

For each sample on which the top adhesive layer and the top electrode film were deposited, an adhesive tape was adhered to a sample surface (upper surface of the top electrode film) and peeled off in an approximately vertical direction. Then, the presence or absence of peeling of the top adhesive layer (top electrode film) was visually confirmed. The evaluation results are shown in Table 2 below. In Table 2, "○ " means that no peeling was observed, and "×" means that peeling was observed.

**[Table 2]**

| Sample No. | Ra1 (nm) | RMS1 (nm) | Result 1 | Result 2 | Average Rz (nm) | Adhesion |
|---|---|---|---|---|---|---|
| 1 | 5.855 | 9.230 | ○ | ○ | 112.8 | ○ |
| 2 | 1.581 | 2.452 | ○ | ○ | 30.67 | ○ |
| 3 | 0.981 | 1.922 | ○ | × | 22.47 | × |
| 4 | 7.150 | 11.30 | ○ | ○ | 150.9 | ○ |
| 5 | 8.860 | 13.47 | × | × | 167.2 | ○ |
| 6 | 7.150 | 10.30 | ○ | ○ | 150.9 | ○ |
| 7 | 7.323 | 10.97 | ○ | ○ | 151.7 | ○ |
| 8 | 1.763 | 2.502 | ○ | ○ | 32.48 | ○ |
| 9 | 1.617 | 2.101 | ○ | ○ | 30.13 | ○ |

From Table 2, it was confirmed that in Samples 1 to 4 and 6 to 9, it was possible to achieve Ra1 of 8 nm or less and RMS1 of 12 nm or less, even though the hetero-oriented rate was more than 10% and 70% or less. That is, it was confirmed that in Samples 1 to 4 and 6 to 9, by depositing the KNN film while rotating the substrate at a rotation speed of 300 rpm or more and 1000 rpm or less, good flatness on the upper surface was achieved even though the KNN film is a highly hetero-oriented film.

It was also confirmed that in Samples 1 to 4 and 6 to 9, Ra2 was 6 nm or less and RMS2 was 8 nm or less over the entire upper surface of the KNN film.

It was also confirmed that in Samples 1, 2, 4, and 6 to 9, Rz was 30 nm or more and 160 nm or less over the entire upper surface of the KNN film.

From Sample 3, it was found that when the rotation speed of the substrate during deposition of the KNN film was more than 1000 rpm, the flatness on the upper surface could be good even though the KNN film was a highly hetero-oriented film, but on the other hand, the adhesion to the top electrode film may be decreased in some cases.

From sample 5, it was confirmed that when the rotation speed of the substrate during deposition of the KNN film was less than 300 rpm, the flatness on the upper surface of the highly hetero-oriented KNN film was poor even when the KNN film was deposited while rotating the substrate.

### <Preferable aspects of the present disclosure>

Preferable aspects of the present disclosure will be described below.

### (Supplementary description 1)

According to one aspect of the present disclosure, there is provided a piezoelectric stack including:
a substrate;
a bottom electrode film on the substrate; and
a piezoelectric film on the bottom electrode film, which is composed of a perovskite oxide represented by a general formula ABO₃, in which A site contains K and Na and B site contains Nb,
wherein measurement of a crystal orientation on an upper surface of the piezoelectric film by electron backscatter diffraction and calculation of an area rate of (001), (110), and (111) show that a percentage of a total area rate of the (110) and the (111) relative to a total area rate of the (001), the (110), and the (111) is more than 10% and 70% or less,
an arithmetic mean roughness on the upper surface is 8 nm or less, and
a root mean square roughness on the upper surface is 12 nm or less.

### (Supplementary description 2)

The piezoelectric stack according to the supplementary description 1, wherein preferably when the upper surface is divided into a plurality of regions of a predetermined size, excluding an outer peripheral region of a predetermined width from an edge, and each of the regions is set as an observation visual field, and an arithmetic mean roughness and a root mean square roughness on the upper surface are calculated using an atomic force microscope for each of the observation visual fields, then, the arithmetic mean roughness is 6 nm or less and the root mean square roughness is 8 nm or less, in 80% or more visual fields out of all the observation visual fields.

### (Supplementary description 3)

The piezoelectric stack according to the supplementary description 2, wherein preferably a maximum roughness (Rz) in height of the upper surface is 30 nm or more and 160 nm or less, in 80% or more visual fields out of all the observation visual fields.

### (Supplementary description 4)

The piezoelectric stack according to any one of the supplementary descriptions 1 to 3, wherein preferably the piezoelectric film contains crystals oriented in a (111) direction in its outermost layer.

### (Supplementary description 5)

The piezoelectric stack according to any one of the supplementary descriptions 1 to 4, wherein preferably an area rate of the (111) on the upper surface is more than 10% (preferably 30% or less).

### (Supplementary description 6)

The piezoelectric stack according to any one of the supplementary descriptions 1 to 5, wherein preferably the piezoelectric film contains crystals oriented in a (110) direction in its outermost layer, and an area rate of the (110) on the upper surface is more than 10%.

### (Supplementary description 7)

The piezoelectric stack according to any one of the supplementary descriptions 1 to 6, wherein preferably the piezoelectric film has a cap layer that constitutes a region ranging from the upper surface to a predetermined depth toward the substrate, and a bulk layer that constitutes a region other than the cap layer, and
the upper surface is an upper surface of the cap layer.

### (Supplementary description 8)

There is provided a piezoelectric stack manufacturing method including:
depositing a bottom electrode film on a substrate; and
depositing a piezoelectric film composed of a perovskite oxide represented by a general formula ABO₃, in which A site contains K and Na and B site contains Nb, on the bottom electrode film by a sputtering method,
wherein the depositing the piezoelectric film includes depositing the piezoelectric film while rotating the substrate on which the bottom electrode film has been deposited, at a rotation speed of 300 rpm or more and 1000 rpm or less.

### (Supplementary description 9)

The piezoelectric stack manufacturing method according to the supplementary description 8, wherein preferably the depositing the piezoelectric film includes:
depositing the piezoelectric film without rotating the substrate on which the bottom electrode film has been deposited; and after the depositing the piezoelectric film without rotating the substrate,
depositing the piezoelectric film while rotating the substrate on which the bottom electrode film has been deposited, under a condition of the rotation speed of 300 rpm or more and 1000 rpm or less.

### (Supplementary description 10)

The piezoelectric stack manufacturing method according to the supplementary description 8 or 9, wherein preferably the depositing the piezoelectric film while rotating the substrate is performed while adjusting an in-plane temperature distribution of the substrate by a temperature adjustment unit so that the in-plane temperature of the substrate gradually increases toward a center of rotation of the substrate.

## Claims

1. A piezoelectric stack comprising:
a substrate;
a bottom electrode film on the substrate; and
a piezoelectric film on the bottom electrode film, which is composed of a perovskite oxide represented by a general formula ABO₃, in which A site contains K and Na and B site contains Nb,
wherein measurement of a crystal orientation on an upper surface of the piezoelectric film by electron backscatter diffraction and calculation of an area rate of (001), (110), and (111) show that a percentage of a total area rate of the (110) and the (111) relative to a total area rate of the (001), the (110), and the (111) is more than 10% and 70% or less,
an arithmetic mean roughness on the upper surface is 8 nm or less, and
a root mean square roughness on the upper surface is 12 nm or less.

2. The piezoelectric stack according to claim 1, wherein when the upper surface is divided into a plurality of regions of a predetermined size, excluding an outer peripheral region of a predetermined width from an edge, and each of the regions is set as an observation visual field, and an arithmetic mean roughness and a root mean square roughness on the upper surface are calculated using an atomic force microscope for each of the observation visual fields, then, the arithmetic mean roughness is 6 nm or less and the root mean square roughness is 8 nm or less, in 80% or more visual fields out of all the observation visual fields.

3. The piezoelectric stack according to claim 2, wherein a maximum roughness (Rz) in height of the upper surface is 30 nm or more and 160 nm or less, in 80% or more visual fields out of all the observation visual fields.

4. The piezoelectric stack according to any one of claims 1 to 3, wherein the piezoelectric film contains crystals oriented in a (111) direction in its outermost layer.

5. The piezoelectric stack according to any one of claims 1 to 4, wherein an area rate of the (111) on the upper surface is more than 10%.

6. The piezoelectric stack according to any one of claims 1 to 5, wherein the piezoelectric film contains crystals oriented in a (110) direction in its outermost layer, and an area rate of the (110) on the upper surface is more than 10%.

7. The piezoelectric stack according to any one of claims 1 to 6, wherein the piezoelectric film has a cap layer that constitutes a region ranging from the upper surface to a predetermined depth toward the substrate, and a bulk layer that constitutes a region other than the cap layer, and
the upper surface is an upper surface of the cap layer.

8. A piezoelectric stack manufacturing method comprising:
depositing a bottom electrode film on a substrate; and
depositing a piezoelectric film composed of a perovskite oxide represented by a general formula ABO₃, in which A site contains K and Na and B site contains Nb, on the bottom electrode film by a sputtering method,
wherein the depositing the piezoelectric film includes depositing the piezoelectric film while rotating the substrate on which the bottom electrode film has been deposited, at a rotation speed of 300 rpm or more and 1000 rpm or less.

9. The piezoelectric stack manufacturing method according to claim 8, wherein the depositing the piezoelectric film includes:
depositing the piezoelectric film without rotating the substrate on which the bottom electrode film has been deposited; and after the depositing the piezoelectric film without rotating the substrate,
depositing the piezoelectric film while rotating the substrate on which the bottom electrode film has been deposited, under a condition of the rotation speed of 300 rpm or more and 1000 rpm or less.

10. The piezoelectric stack manufacturing method according to claim 8 or 9,
wherein the depositing the piezoelectric film while rotating the substrate is performed while adjusting an in-plane temperature distribution of the substrate by a temperature adjustment unit so that the in-plane temperature of the substrate gradually increases toward a center of rotation of the substrate.
